# EUROPÄISCHE PATENTSCHRIFT

(11) **EP 1 186 052 B1**
(45) Veröffentlichungstag und Bekanntmachung des Hinweises auf die Patenterteilung: **18.07.2007**
(21) Anmeldenummer: 00940178.7
(22) Anmeldetag: 10.05.2000
(51) Int. Cl.: H01L 29/417, H01L 29/78, H01L 29/08, H01L 29/423

(54) **SOURCE-DOWN-LEISTUNGSTRANSISTOR**
SOURCE-DOWN POWER TRANSISTOR
TRANSISTOR DE PUISSANCE DONT LA SOURCE EST SITUEE SUR LA FACE INFERIEURE

(30) Priorität: 21.05.1999 DE 19923522
(43) Veröffentlichungstag der Anmeldung: 13.03.2002
(73) Patentinhaber: Infineon Technologies AG, 81669 München (DE)
(72) Erfinder: TIHANYI, Jenö, D-85551 Kirchheim (DE)
(74) Vertreter: Kottmann, Heinz Dieter
(86) Internationale Anmeldenummer: PCT/DE2000/001459
(87) Internationale Veröffentlichungsnummer: WO 2000/072359

(56) Entgegenhaltungen:
- EP-A- 0 833 386
- US-A- 5 719 425

## Beschreibung

Die vorliegende Erfindung betrifft einen Source-Down-Leistungstransistor mit einem zwei zueinander gegenüberliegende Oberflächen aufweisenden Halbleiterkörper aus einem Halbleitersubstrat des einen Leitungstyps und mindestens einer darauf vorgesehenen Halbleiterschicht des anderen Leitungstyps.

Bisher ist ein praktisch realisierter Leistungstransistor in der Patentanmeldung EP0 833386 vorgeschlagen worden, dessen Source-Elektrode an der "Unterseite" eines Halbleiterkörpers gelegen ist, also auf der Hauptoberfläche des Halbleiterkörpers, die der Hauptoberfläche mit der Gate-Elektrode und in diesem Fall auch der Drain-Elektrode gegenüberliegt. Ein solcher MOS-Leistungstransistor ist für viele Anwendungen von großem Vorteil, was insbesondere die Kühlung auf einer auf 0 V Potential liegenden Kühlfahne, wie beispielsweise dem Karosserieanschluß in einem Kraftfahrzeug, anbelangt. Gerade in einem solchen Fall ist dann nämlich keine sonst die Wärmeleitung reduzierende elektrische Isolation zu der Kühlfahne notwendig.

Dieser Leistungstransistor beinhaltet nur einen sich zwischen Source- und Drainzone erstreckenden Graben, der eine Gateelektrode bildet und dessen Kanalgebiet entlang dem Grabenboden läuft. Ein ein leitfähiges Material enthaltender Trench bildet den Kurzschluß zwischen hochdotiertem Sourcebereich und Substrat in diesem Leistungstransistor.

Es ist Aufgabe der vorliegenden Erfindung, einen Source-Down-Leistungstransistor zu schaffen, der sich durch einen einfachen Aufbau auszeichnet und ohne Schwierigkeiten hergestellt werden kann.

Diese Aufgabe wird bei einem Source-Down-Leistungstransistor der eingangs genannten Art erfindungsgemäß dadurch gelöst, daß
- im Bereich zwischen der dem Halbleitersubstrat gegenüberliegenden einen Oberfläche des Halbleiterkörpers bis zu dem Halbleitersubstrat ein erstes hochdotiertes Gebiet des einen Leitungstyps vorgesehen ist, das zusammen mit dem Halbleitersubstrat eine Sourcezone bildet,
- von der einen Oberfläche aus in der mindestens einen Halbleiterschicht im Abstand vom ersten Gebiet ein zweites hochdotiertes Gebiet des einen Leitungstyps vorgesehen ist, das eine Drainzone bildet, die im Abstand vom Halbleitersubstrat endet,
- im Bereich zwischen den beiden Gebieten und unmittelbar an sie angrenzend eine Mehrzahl von schmalen, mit ihrer Längsrichtung sich zwischen den beiden Gebieten erstreckenden Trenches vorgesehen ist, die mit einer Isolierschicht ausgekleidet und mit leitendem Material gefüllt sind, das eine Gateelektrode bildet, und
- auf der die andere Oberfläche des Halbleiterkörpers bildenden Seite des Halbleitersubstrats eine Sourceelektrode vorgesehen ist.

Der erfindungsgemaße Source-Down-Leistungstransistor weist also ein Halbleitersubstrat des einen Leitungstyps auf, das vorzugsweise n⁺-dotiert ist. Auf diesem n⁺-leitenden Halbleitersubstrat, beispielsweise einer n⁺-leitenden Siliziumscheibe, ist wenigstens eine p⁻-leitende Halbleiterschicht vorgesehen, die 5 µm dick sein kann. In bevorzugter Weise befinden sich auf dem Halbleitersubstrat mehrere solche p⁻-leitende Schichten.

Die p⁻-leitenden Schichten konnen epitaktisch hergestellt und nacheinander so abgeschieden werden, daß sie jeweils die angegebene Dicke von etwa 5 µm erreichen. In Oberflächenbereiche dieser epitaktisch abgeschiedenen Schichten wird an Stellen, an denen später eine Sourcezone bzw. eine Drainzone liegen soll, eine n⁺-Dotierung durch Implantation eingebracht. Nach Abscheidung aller p-leitenden Schichten mit anschließender Implantation von n⁺-Dotierungen wird eine Hochtemperaturbehandlung vorgenommen, so daß die implantierten n⁺-Dotierungen ineinander diffundieren und schließlich säulenartige n⁺-leitende Gebiete bilden. Eines dieser Gebiete, das bis zu dem n⁺-leitenden Halbleitersubstrat reicht, stellt eine Source-Zone dar, während das andere Gebiet, das vor Erreichen des Halbleitersubstrates endet, also beispielsweise nicht über die unterste epitaktische Schicht hinausgeht, eine Drain-Zone bildet.

Im Bereich zwischen der Source-Zone und der Drain-Zone wird sodann eine Vielzahl von schmalen Trenches bzw. Gräben geätzt, deren Längsrichtung parallel zu der Richtung zwischen Source-Zone und Drain-Zone verläuft und die eine Breite von etwa 0,1 µm bis einigen µm haben können. Diese Trenches haben eine Tiefe, die ungefähr der Tiefe der Drain-Zone entspricht. Die Trenches werden sodann in ihren Wänden und am Boden mit einer Isolierschicht aus beispielsweise Siliziumdioxid überzogen und mit n⁺-leitendem polykristallinem Silizium oder einem anderen geeigneten leitenden Material gefüllt. Auf diese Weise entstehen in der wenigstens einen epitaktischen Schicht an den Seitenwänden der Trenches steuerbare Stromkanäle.

Die Drain-Zone wird sodann ganzflächig mit einer Metallisierungsebene verbunden, und die Gate-Elektrode bzw. der p-leitende Body-Bereich aus der wenigstens einen p-leitenden epitaktischen Schicht werden schließlich einmal oder mehrmals kontaktiert.

Bei Anlegen einer positiven Drain-Spannung an die Drain-Zone über die Drain-Elektrode und einer positiven Gate-Spannung an die Gate-Elektrode wird auf den Seitenwänden der Trenches ein Inversionskanal gebildet, so daß dort ein Strom fließt. Dieser Strom kann mit der Veränderung der Gate-Spannung ohne weiteres gesteuert werden. Die Einsatzspannung des so aufgebauten Source-Down-Leistungstransistors hängt dabei von der Dotierungskonzentration in der wenigstens einen p-leitenden epitaktischen Schicht ab.

Die angegebenen Leitungstypen können selbstverständlich auch umgekehrt werden, so daß der eine Leitungstyp der p-Leitungstyp ist und damit das Halbleitersubstrat beispielsweise p⁺-dotiert ist. In diesem Fall sind die epitaktischen Schicht n-leitend.

Die Drain-Zone kann gegebenenfalls auch aus mehreren hochdotierten Gebieten bestehen, die so mehrere Abschnitte bilden. Die Dotierung dieser einzelnen Abschnitte kann dabei durch die Größe der Maskenöffnung bei der Implantation der n⁺-Dotierungen frei eingestellt werden. Vorzugsweise weisen diese mehreren hochdotierten Gebiete aber mit zunehmender Entfernung von den Trenches eine höhere Dotierungskonzentration auf. Auf diese Weise ist ein LDD-Aufbau für höhere Spannungsfestigkeit möglich (LDD = schwach dotierte Drain).

Bei Verwendung von mehreren Abschnitten für die Drain-Zone kann wenigstens eines der jeweiligen säulenartigen Gebiete mit einer "Metallseele" oder einer sehr hoch dotierten Polysiliziumseele versehen werden, was zwar das Herstellungsverfahren relativ kompliziert macht, jedoch den Einschaltwiderstand des Leistungstransistors beträchtlich senkt.

Nachfolgend wird die Erfindung anhand der Zeichnungen näher erläutert. Es zeigen:
- Fig. 1: eine Schnittdarstellung des erfindungsgemäßen Source-Down-Leistungstransistors längs einer Linie A-A in Fig. 2,
- Fig. 2: eine Draufsicht auf den Source-Down-Leistungstransistor von Fig. 1 und
- Fig. 3: eine Draufsicht auf ein anderes Ausführungsbeispiel der Erfindung mit einer aus mehreren Abschnitten bestehenden Drain-Zone.

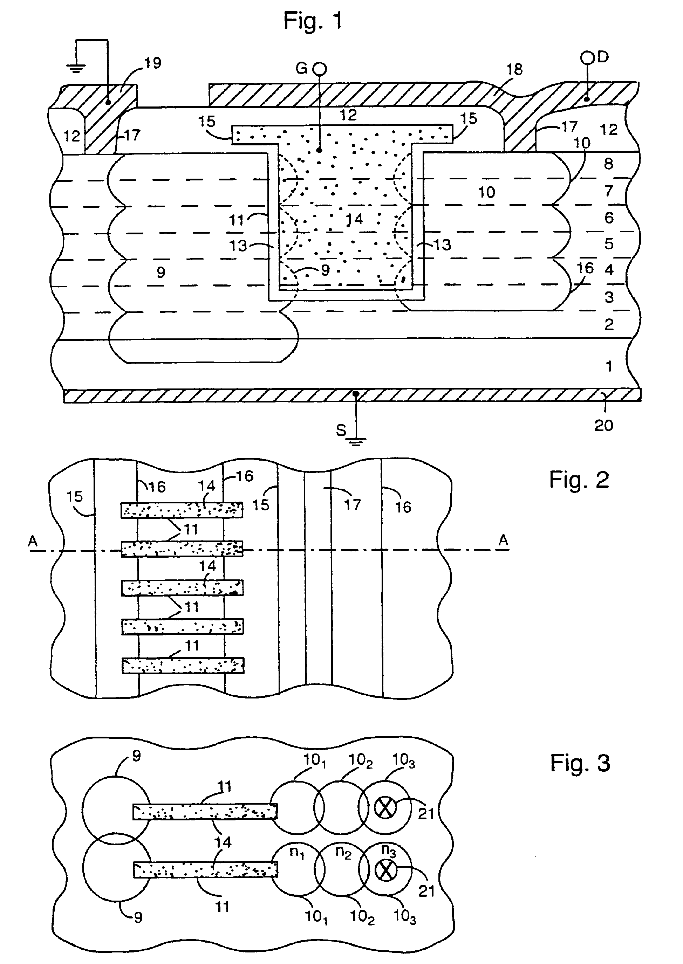

Fig. 1 zeigt ein n⁺-dotiertes Silizium-Substrat 1, auf dem sich übereinander p-leitende epitaktische Schichten 2 bis 8 befinden. Diese p-leitenden epitaktischen Schichten 2 bis 8 werden nacheinander abgeschieden, wobei nach jedem Abscheiden einer epitaktischen Schicht und vor dem Abscheiden der nächsten epitaktischen Schicht in die Oberfläche der bereits abgeschiedenen epitaktischen Schicht an den Stellen von späteren säulenartigen Source- und Drain-Zonen 9 bzw. 10 n⁺-Dotierungen durch Implantation eingebracht werden. Nach Abscheidung und Implantation aller p-leitenden Schichten 2 bis 8 bzw. aller n⁺-Dotierungen werden durch eine Hochtemperaturbehandlung die implantierten n⁺-Dotierungen übereinander diffundiert, so daß, wie in Fig. 1 gezeigt ist, die säulenartige Source-Zone 9 und die säulenartige Drain-Zone 10 entstehen. Diese Zonen 9 und 10 sind dabei n⁺-dotiert.

Sodann werden in den Bereich zwischen den Zonen 9, 10 schmale Trenches 11 (vgl. Fig. 2) geätzt, die parallel zueinander sind und im wesentlichen in der Richtung zwischen der Zone 9 und der Zone 10 verlaufen. Diese Trenches 11 durchsetzen beispielsweise die epitaktischen Schichten 4 bis 8 und haben so eine Tiefe von etwa 25 µm, wenn jede der einzelnen epitaktischen Schichten 2 bis 8 eine Schichtdicke von etwa 5 µm aufweist. Die Trenches werden sodann mit einer Isolierschicht 13 aus beispielsweise Siliziumdioxid und/oder Siliziumnitrid ausgekleidet und mit n⁺-dotiertem polykristallinem Silizium 14 gefüllt, das bis zu einer "Polykante" 15 reicht. In den Bereichen zwischen den Trenches 11 erstrecken sich die n⁺-leitende Source-Zone 9 bzw. die n⁺-leitende Drain-Zone 10 bis zu einer "n⁺-Kante" 16 (vgl. Fig. 2).

Nach Aufbringen einer Isolierschicht 12 aus beispielsweise Siliziumdioxid werden in diese Kontaktlöcher 17 für eine Drain-Metallisierung 18 aus Aluminium bzw. einen Body-Kontakt 19 aus ebenfalls Aluminium eingebracht, und eine Gateelektrode G wird mit dem polykristallinen Silizium 14 verbunden. Schließlich wird noch auf das Halbleitersubstrat 1 eine Metallschicht 20 aus beispielsweise Aluminium aufgetragen, welche als Source-Kontakt dient.

Die Trenche 11 mit dem polykristallinen Silizium 14 sind schmal und erstrecken sich zwischen der Source-Zone 9 und der Drain-Zone 10. Auf ihren Seitenwänden bilden sich steuerbare Inversionskanäle, wenn eine positive Drainspannung U_{D} an die Drainelektrode D und eine positive Gatespannung an die Gateelektrode G angelegt werden, so daß ein Strom fließt. Dieser Strom kann mit der Veränderung der Gatespannung gesteuert werden.

Auf diese Weise wird ein Source-Down-Leistungstransistor erhalten, dessen Source-Elektrode S an der "Unterseite" angeordnet ist und dort beispielsweise auf einer Kühlfahne, die auf 0 V Potential liegt, angebracht werden kann. Dieser Source-Down-Leistungstransistor ist mit üblichen Verfahrensschritten relativ einfach herstellbar, wie dies oben erläutert wurde. Es sind hierzu lediglich verschiedene Epitaxie-Schritte mit Implantationen sowie das Einbringen mehrerer Trenches erforderlich.

Fig. 3 zeigt ein weiteres Ausführungsbeispiel der Erfindung, wobei hier jedem Trench 11 eine Source-Zone 9 und mehrere Drain-Zonen 10₁, 10₂, 10₃ mit Dotierungskonzentrationen n₁, n₂ bzw. n₃ zugeordnet sind. Dabei gilt für die Dotierungskonzentrationen n₁ < n₂ < n₃ = n⁺. Auf diese Weise kann eine "LDD"-Struktur hergestellt werden, die besonders für höhere Spannungen geeignet ist. Es ist dabei vorteilhaft, wenn in der Zone 10₃ eine hochleitende "Seele" 21 aus Metall oder polykristallinem Silizium vorgesehen wird. Durch eine solche "Seele" 21 läßt sich der Einschaltwiderstand des Source-Down-Leistungstransistors vermindern.

Die Größe der jeweiligen Dotierungen n₁, n₂ und n₃ in den Zonen 10₁, 10₂ und 10₃ kann durch die Größe der Maskenöffnung bei den n⁺-Dotierungen in den jeweiligen epitaktischen Schichten frei eingestellt werden.

Bei dem Ausführungsbeispiel der Fig. 3 bilden die Zonen 10₁, 10₂ und 10₃ jeweils Abschnitte der Drain-Zone 10. Das heißt, die säulenartige Drain-Zone 10 ist hier aus mehreren Abschnitten hergestellt.

## Patentansprüche

1. Source-Down-Leistungstransistor mit einem zwei einander gegenüberliegende Oberflächen aufweisenden Halbleiterkörper aus einem Halbleitersubstrat (1) des einen Leitungstyps und mindestens einer darauf vorgesehenen Halbleiterschicht (2 bis 8) des anderen Leitungstyps,
**dadurch gekennzeichnet, daß**
- im Bereich zwischen der dem Halbleitersubstrat (1) gegenüberliegenden einen Oberfläche des Halbleiterkörpers bis zu dem Halbleitersubstrat (1) ein erstes hochdotiertes Gebiet (9) des einen Leitungstyps vorgesehen ist, das zusammen mit dem Halbleitersubstrat (1) eine Source-Zone bildet,
- von der einen Oberfläche aus in der mindestens einen Halbleiterschicht (2 bis 8) im Abstand vom ersten Gebiet (9) ein zweites hochdotiertes Gebiet (10) des einen Leitungstyps vorgesehen ist, das eine Drainzone bildet, die im Abstand vom Halbleitersubstrat (1) endet,
- im Bereich zwischen den beiden Gebieten (9, 10) und unmittelbar an sie angrenzend eine Mehrzahl von schmalen, mit ihrer Längsrichtung sich zwischen den beiden Gebieten (9, 10) erstreckenden Trenches (11) vorgesehen ist, die mit einer Isolierschicht (13) ausgekleidet und mit leitendem Material (14) gefüllt sind, das eine Gateelektrode bildet, und
- auf der die andere Oberfläche des Halbleiterkörpers bildenden Seite des Halbleitersubstrats (1) eine Sourceelektrode (20) vorgesehen ist.

2. Source-Down-Leistungstransistor nach Anspruch 1,
**dadurch gekennzeichnet, daß** die Schichtdicke der mindestens einen Halbleiterschicht (2 bis 8) etwa 5 µm beträgt.

3. Source-Down-Leistungstransistor nach Anspruch 1 oder 2,
**dadurch gekennzeichnet, daß** mehrere zweite hochdotierte Gebiete (10₁, 10₂, 10₃) vorgesehen sind, die in Längsrichtung der Trenche (11) hintereinander liegen und mit zunehmender Entfernung von den Trenches (11) eine höhere Dotierungskonzentration aufweisen.

4. Source-Down-Leistungstransistor nach Anspruch 3,
**dadurch gekennzeichnet, daß** wenigstens einer der zweiten Gebiete (10₁, 10₂, 10₃) einen Kernbereich (21) mit leitendem Material aufweist.

5. Source-Down-Leistungstransistor nach Anspruch 4,
**dadurch gekennzeichnet, daß** das leitende Material polykristallines Silizium ist.

## Claims

1. Source-down power transistor having a semiconductor body having two mutually opposite surfaces and comprising a semiconductor substrate (1) of the first conduction type and at least one semiconductor layer (2 to 8) - provided thereon - of the second conduction type,
**characterized in that**
- a first highly doped region (9) of the first conduction type is provided in the region between the first surface of the semiconductor body, said surface being opposite to the semiconductor substrate (1), and as far as the semiconductor substrate (1), which highly doped region forms a source zone together with the semiconductor substrate (1),
- from the first surface, a second highly doped region (10) of the first conduction type is provided in the at least one semiconductor layer (2 to 8) at a distance from the first region (9), which highly doped region forms a drain zone which ends at a distance from the semiconductor substrate (1),
- a plurality of narrow trenches (11) extending between the two regions (9, 10) with their longitudinal direction are provided in the region between the two regions (9, 10) and directly adjacent thereto, which trenches are lined with an insulating layer (13) and filled with conductive material (14), which forms a gate electrode, and
- a source electrode (20) is provided on that side of the semiconductor substrate (1) which forms the second surface of the semiconductor body.

2. Source-down power transistor according to Claim 1,
**characterized in that**
the layer thickness of the at least one semiconductor layer (2 to 8) is about 5 µm.

3. Source-down power transistor according to Claim 1 or 2,
**characterized in that**
provision is made of a plurality of second highly doped regions (10₁, 10₂, 10₃), which lie one behind the other in the longitudinal direction of the trenches (11) and have a higher doping concentration with increasing distance from the trenches (11).

4. Source-down power transistor according to Claim 3,
**characterized in that**
at least one of the second regions (10₁, 10₂, 10₃) has a core region (21) with conductive material.

5. Source-down power transistor according to Claim 4,
**characterized in that**
the conductive material is polycrystalline silicon.

## Revendications

1. Transistor de puissance dont la source est sur la face inférieure, comprenant un corps semiconducteur ayant deux surfaces opposées l'une à l'autre en un substrat (1) semiconducteur d'un type de conductivité et au moins une couche (2 à 8) de semiconducteur prévue dessus et de l'autre type de conductivité,
**caractérisé en ce que**
- dans la partie comprise entre l'une des surfaces, opposée au substrat (1) semiconducteur, du corps semiconducteur jusqu'au substrat (1) semiconducteur est prévue une première zone (9) très dopée du un type de conductivité qui, ensemble avec le substrat (1) semiconducteur, forme une zone source,
- à partir de la une surface il est prévu dans la au moins une couche (2 à 8) de semiconducteur, à distance de la première zone (9) une deuxième zone (10) très dopée du un type de conductivité, qui forme une zone de drain se terminant à distance du substrat (1) semiconducteur,
- dans la partie comprise entre les deux zones (9, 10) et en étant directement voisines, il est prévu une multiplicité de sillons (11) s'étendant par leur direction longitudinale entre les deux zones (9, 10), revêtus d'une couche (13) isolante et remplis d'une matière (14) conductrice qui forme une électrode de grille et,
- du côté du substrat (1) semiconducteur formant l'autre surface du corps semiconducteur est prévue une électrode (20) de source.

2. Transistor de puissance dont la source est sur la face inférieure suivant la revendication 1,
**caractérisé en ce que**
l'épaisseur de la au moins une couche (2 à 8) de semiconducteur est d'environ 5 µm.

3. Transistor de puissance dont la source est sur la face inférieure suivant la revendication 1 ou 2,
**caractérisé en ce qu'**il est prévu plusieurs deuxièmes zones (10₁, 10₂, 10₃) très dopées, qui se succèdent dans la direction longitudinale des sillons (11) et qui ont une concentration de dopage de plus en plus grande au fur et à mesure qu'augmente l'éloignement des sillons (11).

4. Transistor de puissance dont la source est sur la face inférieure suivant la revendication 3, **caractérisé en ce qu'**au moins l'une des deuxièmes zones (10₁, 10₂, 10₃) a une partie (21) de coeur ayant de la matière conductrice.

5. Transistor de puissance dont la source est sur la face inférieure suivant la revendication 4, **caractérisé en ce** la matière conductrice est du silicium polycristallin.
